(19) **Europäisches Patentamt**

**European Patent Office**

**Office européen des brevets**

(11) **EP 1 026 509 B1**

(12) **EUROPEAN PATENT SPECIFICATION**

(45) Date of publication and mention
of the grant of the patent:
**19.04.2006 Bulletin 2006/16**

(51) Int Cl.:
***G01R 23/20*** *(2006.01)*

(21) Application number: **00660019.1**

(22) Date of filing: **07.02.2000**

(54) **Method and apparatus for determining harmonics in electric network**

Verfahren und Vorrichtung zum Feststellen von Oberwellen in einem elektrischen Netz

Procédé et dispositif de détermination des harmoniques dans un réseau électrique

(84) Designated Contracting States:
**DE FR GB**

(30) Priority: **08.02.1999 FI 990239**

(43) Date of publication of application:
**09.08.2000 Bulletin 2000/32**

(73) Proprietor: **ABB Oy**
**00380 Helsinki (FI)**

(72) Inventors:
• **Lehtinen, Reijo**
**33100 Tampere (FI)**
• **Marjusaari, Ville**
**33720 Tampere (FI)**

(74) Representative: **Peltonen, Antti Sakari et al**
**Kolster Oy Ab,**
**Iso Roobertinkatu 23,**
**P.O. Box 148**
**00121 Helsinki (FI)**

(56) References cited:
**EP-A- 0 758 750**

• **MILLER A J V ET AL: "The Application Of Multi-Rate Digital Signal Processing Techniques To The Measurement Of Power System Harmonic Levels" CONFERENCE PROCEEDINGS ARTICLE IEEE, 22 September 1992 (1992-09-22), pages 7-15, XP010207823**

**Description**

BACKGROUND OF THE INVENTION

The invention relates to a method and apparatus for determining harmonics in an electric network .

Determination of harmonic amplitudes of voltages and currents in an electric network is one way of controlling the electric network , thus allowing to monitor the quality of electricity in the network. Harmonics are caused in the electric network by different power converters, for example. When the proportion of voltage and current harmonics exceeds a certain limit in the electric network , the quality of electricity is impaired considerably. Furthermore, electricity of poor quality may lead to breakdowns and defects in electric equipment and in the distribution of electricity. Monitoring of harmonics often involves relay protection which allows to separate clearly faulty sections of the electric network from the rest of the network.

Furthermore, one needs to be able to calculate harmonic amplitudes with sufficient accuracy even though the fundamental frequency of the network would differ from its nominal value. To obtain sufficient frequency separation, the harmonic amplitudes must be calculated using a calculation window with long duration in embodiments based on sampling. Buffering of samples and calculation of amplitudes after the buffer has filled up require a lot of memory and two functions timed at different frequencies: one for collecting samples into the buffer and the other for calculating the results from the buffered samples.

Both analogue and digital devices have been used for calculating harmonics. In analogue devices the signal is filtered by band-pass filters the passbands of which are at the presumed harmonic frequencies. Harmonic amplitudes are obtained from the amplitudes of the filtered signals.

In digital systems, harmonic amplitudes have been calculated by means of discrete Fourier transformation (DFT) using Fast Fourier transformation (FFT) which is efficient in calculation. The DFT maps the time domain to the frequency domain, and thus the amplitudes are obtained directly from the amplitude values given to the harmonic frequencies by the DFT. A method based on the use of a filter bank comprising several digital filters is disclosed in Thong, T., *Practical Consideration for a continuous time digital spectrum analyzer,* Proceedings of the IEEE International Symposium on Circuits and Systems, 1989, pp. 1047-1050. This method is based on the calculation of the DFT from a narrowly windowed signal.

There are also methods which are independent of the network's fundamental frequency. For example, in the method according to US Patent No. 5,615,302 the result is obtained by calculations at several frequency points given by the DFT by using a method called 'ratio detection'. In the method according to US Patent No. 5,528,134, a signal is resampled by software to provide a sampling frequency which is a multiple of the base frequency.

MILLER A.J.V. ET AL. The application of multi-rate digital signal processing techniques to the measurement of power system harmonics level of Conference Proceedings Article IEEE, 22 septembre1992, pages 7-15.

Disadvantages associated with analogue applications include the large number of analogue filters needed and errors caused by component tolerances, temperature changes, breakdowns and overheating.

A problem related to prior art digital methods based on the DFT is that they are sensitive to frequency deviation. The method based on resampling is disadvantageous because resampling requires calculations, which causes inaccuracies. The weaknesses of the ratio detection method include the large number of calculations needed and numerical problems in practical situations.

A common disadvantage of all methods based on the DFT and FFT is that they require buffering and thus different functions for collecting data into a buffer and for analysing buffered data. If the problem of buffering cannot be solved in the system by means of an apparatus, e.g. by means of direct memory access (DMA), a separate software process timed at a different frequency is needed for buffering in addition to the analysing program. In a three-phase system, determination of harmonic amplitudes requires data buffering for each phase and two alternating buffers for each phase to ensure adequate temporal scope.

BRIEF DESCRIPTION OF THE INVENTION

The object of the present invention is to provide a method which eliminates the above-mentioned drawbacks and allows determination of harmonics in an electric network in a reliable and simple manner. This object is achieved with the method of the invention which comprises the steps of establishing a filter bank which comprises several digital and complex band-pass filters and in which the combined width of the filter passband and one transition band is at most equal to the minimum value of the base frequency of the property to be determined in the electric network and the passbands of two parallel filters in the filter bank overlap N times the fluctuation of the fundamental frequency which is required by the order of the filter and occurs during the time difference between the first and the last sample of a sample group, N being the ordinal of the highest harmonic to be measured; sampling the property of the electric network to be determined to obtain samples; supplying the samples to the filter bank; estimating the fundamental frequency of the property to be determined on the basis of the samples; choosing, on the basis of frequency estimation, the filters from the outputs of which the amplitude of each frequency component can be calculated; and calculating the amplitudes of the fundamental and harmonic components of the property to be determined from the outputs of the filter bank filters.

The method of the invention is based on the idea that harmonic amplitudes can be calculated efficiently in the electric network using a filter bank consisting of several band-pass filters. According to the invention, the filter bank filter to be used for calculating the amplitude of each frequency component is selected on the basis of frequency estimation, in which case the passbands of the filters in the filter bank may overlap and do not need to have the properties required of filters used in spectrum estimation. Since the filters overlap, the estimation accuracy of harmonic amplitudes can be improved by a simple solution. The amplitudes of the harmonics in the passband of the filters in question can be calculated in a simple manner from the outputs of the filter bank filters. An advantage of the method according to the invention is that the amount of calculation capacity needed to implement the method is very small compared to the prior art solutions. Furthermore, samples do not need to be buffered into separate buffers because harmonic amplitudes can be calculated directly in real time more accurately than previously.

The invention also relates to an apparatus for determining harmonics in an electric network , the apparatus comprising a sampling member which is arranged to sample the property of the electric network to be determined, it also comprises a filter bank which comprises several digital and complex band-pass filters and in which the combined width of the filter passband and one transition band is at most equal to the minimum value of the base frequency of the property to be determined in the electric network and the passbands of two parallel filters in the filter bank overlap N times the fluctuation of the fundamental frequency which is required by the order of the filter and occurs during the time difference between the first and the last sample of a sample group, N being the ordinal of the highest harmonic to be measured; a frequency estimation member which is arranged to select the filter bank filters in the passband of which the harmonic amplitudes of the property to be determined occur, and a processing member provided for the filter bank for determining the amplitudes of the fundamental and harmonic components of the property to be determined.

This kind of apparatus allows to implement the advantageous method of the invention in a simple manner.

BRIEF DESCRIPTION OF THE DRAWINGS

The invention will be described in greater detail by means of preferred embodiments with reference to the accompanying drawings, in which

Figure 1 illustrates properties of filter bank filters in relation to harmonic components;
Figure 2 illustrates frequency fluctuation, if any, in relation to the passbands of the filter bank filters;
Figure 3 illustrates a filter bank according to the invention in polyphase form;
Figure 4 illustrates an example of how the filters of an equidistant filter bank are situated in the frequency domain; and
Figure 5 is a block diagram of a system employing the method of the invention.

DETAILED DESCRIPTION OF THE INVENTION

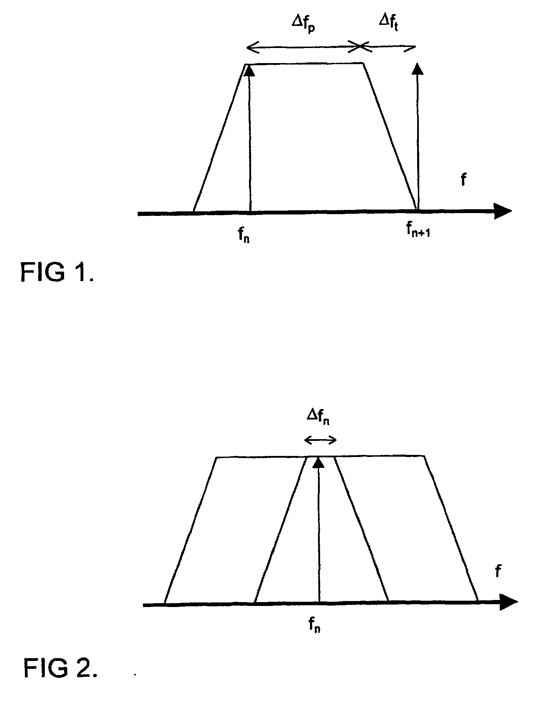

According to the invention, a filter bank comprising several digital and complex band-pass filters is established when harmonic amplitudes are being determined in an electric network . The bands of the filter bank are designed to cover the whole range where the harmonics to be analysed may occur. According to Figure 1, the filters of the bank are designed so that the filter bank comprises at least one filter in the passband of which the harmonic occurs and no other harmonics occur in these passbands and transition bands of the filters. Thus other harmonic frequencies, including the fundamental frequency, occur in the stop band of the filter in question. Mathematically expressed, in the filter the stop band width $\Delta f_p$ and the transition band widths $\Delta f_t$ must fulfil the condition $\Delta f_p + \Delta f_t < f_{min}$ where $f_{min}$ is the minimum value of the fundamental frequency. According to Figure 2, the passbands are designed to overlap by the frequency fluctuation $\Delta f$ that takes place during the filter length. For the harmonic N, the bands must overlap N times the fundamental frequency. The passbands of filters are made sufficiently flat to allow error transfer into the estimate of the harmonic amplitude. Correspondingly, damping of the stop band is designed to allow transfer of errors caused by frequency components occurring in the stop band directly into the estimate of the harmonic amplitude.

In accordance with the invention, the property of the electric network to be determined, such as voltage or current, is sampled to obtain discrete samples. The samples are utilized for calculating the harmonic amplitudes of the property to be determined. According to the invention, the samples are used for estimating the fundamental frequency of the signal, on the basis of which the correct filter bank bands are selected for calculating each harmonic. Since the filter bank filters are designed according to the example shown in Figure 1, any one of the filters in the passband of which the frequency component to be examined occurs according to the fundamental frequency estimated over the filter length can be chosen as the filter of each frequency component. According to the invention, the samples are supplied to the filter bank filters selected on the basis of frequency estimation and the harmonic amplitudes of the property to be determined are calculated from the outputs of the filter bank.

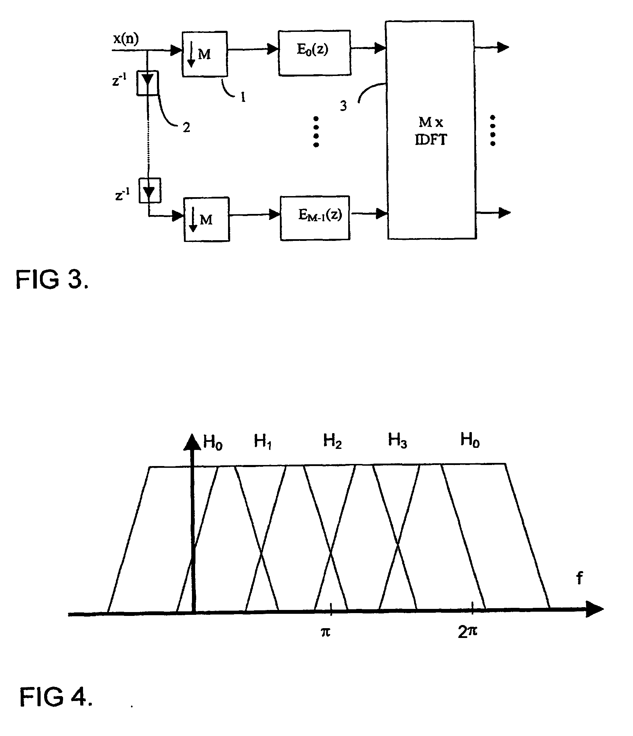

The filter bank is preferably an equidistant DFT filter bank. Figure 4 illustrates an example of how the filters of an equidistant DFT filter bank are situated in the frequency domain. A filter bank is called an equidistant DFT bank if all filters of the filter bank are derived from the basic filter $H_0(z)$ as follows

$$H_k(z) = H_0(zW_M^k), \ 0 \le k \le M-1.$$

The amplitude responses of the filter $H_k(z)$ are equidistantly shifted versions of the amplitude responses of the basic filter $H_0(z)$. The basic filter $H_0$ and the number M of bands are designed to fulfil the conditions according to above-mentioned Figures 1 and 2.

The equidistant DFT filter bank is preferably implemented using a polyphase structure. In polyphase form the basic filter $H_0(z)$ can be expressed as follows

$$H_0(z) = \sum_{k=0}^{M-1} z^{-k} E_k(z^M),$$

where $E_k$ is the $k^{th}$ polyphase component of the basic filter $H_0(z)$

$$E_k(z) = \sum_{n=0}^{\infty} e_k(n)z^{-n} = \sum_{n=0}^{\infty} h_0(k+nM)z^{-n}, \ 0 \le k \le M-1.$$

Furthermore, by replacing z with $zW^k_M$, we obtain the polyphase from of band M for the filters $H_k(z)$

$$H_k(z) = \sum_{n=0}^{M-1} W_M^{-kn} z^{-n} E_n(z^M).$$

The filters $E_n(z^M)$ of the previous equation correspond to filter $E_n(z)$ of Figure 3 and to decrease of the sampling frequency by M in downsampling blocks 1. In that case $z^{-n}E_n(z^M)$ of the previous equation corresponds to unit delays $z^{-1}$, decrease of the sampling frequency by M and filters $E_n(z)$ in the block diagram of Figure 3. The remaining term $W_M^{-kn}$ is a way of representing expression $e^{-j2\pi nk/M}$.

The definition of the inverse discrete Fourier transformation has the form of

$$x(n) = \sum_{k=0}^{N-1} X(k)W_N^{-nk} \ n = 0, 1, ..., N-1,$$

where terms X(k) correspond to inputs into the IDFT block in Figure 3, and thus the inverse Fourier transformation is calculated from these inputs. This means that the output of the sub-filter $H_k(z)$ can be calculated from the outputs of the IDTF polyphase filters $E_0(z)...E_{M-1}(z)$.

The inverse Fourier transformation is calculated from each M band, i.e. in Figure 3 from the signal arriving in the IDFT block 3 from M, but according to the invention, this transformation is calculated only for the bands in which a harmonic component occurs according to frequency estimation. The inverse Fourier transformation yields harmonic components in the time domain, and consequently the amplitude can be calculated from the real and imaginary parts of the signal obtained simply by taking a square root of the square sum of the components.

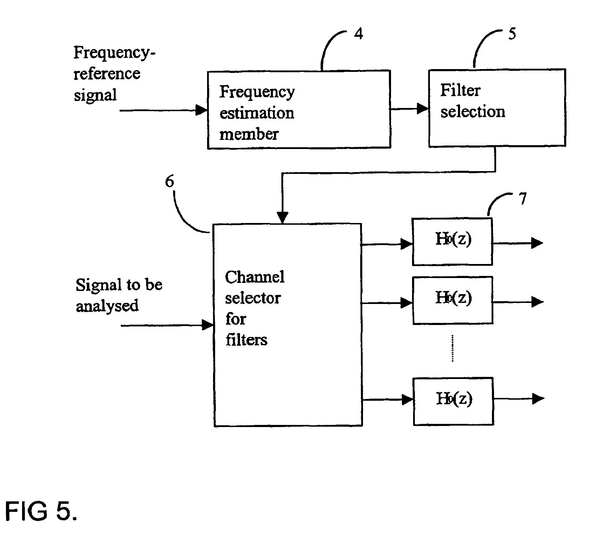

Figure 5 is a block diagram illustrating the operating principle of a system employing the method according to the invention. The fundamental frequency of an incoming signal is estimated by means of a frequency estimation member 4. The frequency estimation member 4 is connected to a selection member 5 which selects the filters, the output of the selection member being further connected to a block 6 which selects the filter channels and which also receives the signal to be analysed in the input. The outputs of the block 6 are further supplied to filters 7 the outputs of which can be used for calculating the amplitude of the property to be determined.

It will be obvious to one skilled in the art that as the technology advances, the inventive concept can be implemented in various ways. Therefore the invention and its embodiments are not limited to the examples described above, but they may vary within the scope of the claims.

## Claims

1. A method of determining harmonics in an electric network , the method comprises the steps of
   establishing a filter bank which comprises several digital and complex band-pass filters;
   sampling the property of the electric network to be determined to obtain samples;
   supplying the samples to the filter bank;
   estimating the fundamental frequency of the property to be determined on the basis of the samples;
   choosing, on the basis of frequency estimation, the filters from the outputs of which the amplitude of each frequency component can be calcu-lated; and
   calculating the amplitudes of the fundamental and harmonic com-ponents of the property to be determined from the outputs of the filter bank filters, **characterised in that** the combined width of the filter passband and one transition band is at most equal to the minimum value of the fundamental frequency of the property to be determined in the electric network and the passbands of two parallel filters in the filter bank overlap N times the fluc-tuation of the fundamental frequency which is required by the order of the filter and occurs during the time difference between the first and the last sample of a sample group, N being the ordinal of the highest harmonic to be measured.

2. A method according to claim 1, **characterized in that** the filter bank used is an equidistant DFT filter bank, the establishment of which comprises the steps of
   establishing a basic filter ($H_0$), and
   establishing harmonic filters ($H_n$) by duplicating and shifting the basic filter equidistantly in the frequency domain.

3. A method according to claim 1 or 2, **characterized in that** the establishment of the filter bank comprises the step of establishing the filter bank using polyphase partition.

4. A method according to claim 3, **characterized in that** the calculation of the amplitudes of the fundamental and harmonic components comprises the steps of
   selecting those filter bank filters in the passband of which a fundamental or a harmonic component of the property to be determined occurs,
   calculating the results of the polyphase representation of the sub-filters in the M band DFT filter bank,
   calculating the inverse Fourier transformation of M point from the results obtained for the polyphase representation of the sub-filters in respect of the selected filters to obtain the magnitude of the real and imaginary parts of the signal supplied to the selected filters when M corresponds to the total number of filters in the filter bank, and
   calculating the amplitude of the harmonic component from the real and imaginary parts obtained in respect of the selected filter bank filters.

5. A method according to any one of claims 1 to 4, **characterized in that** the property to be determined is the voltage or current in the electric network.

6. An apparatus for determining harmonics in an electric network, the apparatus comprising a sampling member which is arranged to sample the property of the electric network to be determined, it also comprises a filter bank which comprises several digital and complex band-pass filters,
   a frequency estimation member which is arranged to select the filter bank filters in the passband of which the harmonic amplitudes of the property to be determined occur, and
   a processing member provided for the filter bank for determining the amplitudes of the fundamental and harmonic components of the property to be determined, **chatacterized in that** the combined width of the filter passband and one transition band is at most equal to the minimum value of the fundamental frequency of the property to be determined in the electric network and the passbands of two parallel filters in the filter bank overlap N times the fluctuation of the fundamental frequency which is required by the order of the filter and occurs during the time difference between the first and the last sample of a sample group, N being the ordinal of the highest harmonic to be measured.

7. An apparatus according to claim 6, **characterized in that** the filter bank is an equidistant DFT filter bank which comprises a basic filter and duplicates of the basic filter shifted equidistantly in the frequency domain.

8. An apparatus according to claim 6 or 7, **characterized in that** the filter bank is established using polyphase partition.

9. An apparatus according to any one of claims 6 to 8, **characterized in that** the processing member is arranged to calculate the results of sub-filters in accordance with the polyphase partition of the DFT filter bank and the amplitude of the property to be determined from the intermediate results of the polyphase partition by means of the IDTF in respect of the filters selected on the basis of the output signals of the filter bank filters.

10. An apparatus according to any one of claims 6 to 9, **characterized in that** the property to be determined is the voltage or current in the electric network.

**Patentansprüche**

1. Verfahren zum Feststellen von Oberwellen in einem elektrischen Netz, die Schritte umfassend:

   Einrichten einer Filterbank, die mehrere digitale und komplexe Bandpassfilter umfasst;
   Abtasten der Eigenschaft des elektrischen Netzes, die festgestellt werden soll, um Abtastwerte zu erhalten;
   Bereitstellen der Abtastwerte für die Filterbank;
   Schätzen der Fundamentalfrequenz der Eigenschaft, die festgestellt werden soll, auf der Basis der Abtastwerte;
   Auswählen, auf der Basis der Frequenzschätzung, der Filter, aus deren Ausgaben die Amplitude jeder Frequenzkomponente berechnet werden kann; und
   Berechnen der Amplituden der fundamentalen und Oberwellen-Komponenten der festzustellenden Eigenschaft aus den Ausgaben der Filterbank-Filter, **dadurch gekennzeichnet, dass**
   die kombinierte Breite des Filterdurchlassbereiches und eines Übergangsbandes höchstens gleich dem Minimalwert der Fundamentalfrequenz der zu festzustellenden Eigenschaft in dem elektrischen Netz ist und
   die Durchlassbereiche zweier paralleler Filter in der Filterbank N-mal die Fluktuation der Fundamentalfrequenz überlappen, die durch die Anordnung der Filter benötigt wird und während des Zeitunterschieds zwischen dem ersten und dem letzten Abtastwert der Abtastwertgruppe auftritt, wobei es sich bei N um die Ordinale der höchsten Oberwelle, die zu messen ist, handelt.

2. Verfahren nach Anspruch 1, **dadurch gekennzeichnet, dass** die verwendete Filterbank eine äquidistante DFT-Filterbank ist, wobei die Einrichtung derselben die Schritte umfasst:

   Einrichten eines Basisfilters ($H_0$), und
   Einrichten harmonischer Filter ($H_n$) durch Kopieren und Verschieben des
   Basisfilters äquidistant in der Frequenzdomäne.

3. Verfahren nach Anspruch 1 oder 2, **dadurch gekennzeichnet, dass** die Einrichtung der Filterbank den Schritt umfasst, die Filterbank unter Verwendung von Polyphasen-Aufteilung einzurichten.

4. Verfahren nach Anspruch 3, **dadurch gekennzeichnet, dass** die Berechnung der Amplituden der fundamentalen und Oberwellen-Komponenten die Schritte umfasst
   Auswählen der Filterbank-Filter in dem Durchlassbereich, von dem eine fundamentale oder eine Oberwellen-Komponente der festzustellenden Eigenschaft auftritt,
   Berechnen der Ergebnisse der Polyphasen-Darstellung der Subfilter in der M-Band DFT-Filterbank,
   Berechnen der inversen Fourier-Transformation von M Punkten aus den Ergebnissen, die für die Polyphasen-Darstellung der Subfilter in Bezug auf die ausgewählten Filter erhalten wurden, um die Größe der reellen und imaginären Teile des Signals zu erhalten, das den ausgewählten Filtern bereitgestellt wurde, wenn M der Gesamtzahl der Filter in der Filterbank entspricht, und
   Berechnen der Amplitude der Oberwellen-Komponente aus den reellen und imaginären Teilen, die in Bezug auf die ausgewählten Filterbankfilter erhalten wurden.

5. Verfahren nach einem der Ansprüche 1-4, **dadurch gekennzeichnet, dass** die festzustellende Eigenschaft die Spannung oder der Strom in dem elektrischen Netz ist.

6. Vorrichtung zum Feststellen von Oberwellen in einem elektrischen Netz, wobei die Vorrichtung ein Abtastteil umfasst, das angeordnet ist, die festzustellende Eigenschaft des elektrischen Netzes abzutasten, wobei sie weiterhin umfasst:

eine Filterbank, die mehrere digitale und komplexe Bandpassfilter umfasst;
ein Frequenzschätzungsteil, das angeordnet ist, die Filterbank-Filter in dem Durchlassbereich zu wählen, in dem die harmonischen Amplituden der festzustellenden Eigenschaft auftreten, und
ein für die Filterbank bereitgestelltes Bearbeitungsteil zum Feststellen der Amplituden der fundamentalen und Oberwellen-Komponenten der festzustellenden Eigenschaft, **dadurch gekennzeichnet, dass**
die kombinierte Breite des Filterdurchlassbereichs und eines Übergangsbandes höchstens gleich dem Minimalwert der Fundamentalfrequenz der festzustellenden Eigenschaft in dem elektrischen Netz ist und die Durchlassbereiche zweier paralleler Filter in der Filterbank N mal der Fluktuation der Fundamentalfrequenz überlappen, die durch die Anordnung der Filter benötigt ist und während des Zeitunterschieds zwischen dem ersten und dem letzten Abtastwert der Abtastwertgruppe auftritt, wobei es sich bei N um die Ordinale der höchsten Oberwelle, die zu messen ist, handelt.

7. Vorrichtung nach Anspruch 6, **dadurch gekennzeichnet, dass** die Filterbank eine äquidistante DFT-Filterbank ist, die einen Basisfilter und Kopien des Basisfilters, die äquidistant in der Frequenzdomäne verschoben sind, umfasst.

8. Vorrichtung nach Anspruch 6 oder 7, **dadurch gekennzeichnet, dass** die Filterbank unter Verwendung von Polyphasen-Aufteilung eingerichtet wird.

9. Vorrichtung nach einem der Ansprüche 6 bis 8, **dadurch gekennzeichnet, dass** das Bearbeitungsteil angeordnet ist, die Ergebnisse der Subfilter in Übereinstimmung mit der Polyphasen-Aufteilung der DFT-Filterbank und die Amplitude der festzustellenden Eigenschaft aus den Zwischenergebnissen der Polyphasen-Aufteilung vermittels der IDTF in Bezug auf die auf der Basis der Ausgangsignale der Filterbank-Filter ausgewählten Filter zu berechnen.

10. Vorrichtung nach einem der Ansprüche 6 bis 9, **dadurch gekennzeichnet, dass** es sich bei der festzustellenden Eigenschaft um die Spannung oder den Strom in dem elektrischen Netz handelt.

**Revendications**

1. Procédé de détermination d'harmoniques dans un réseau électrique, le procédé comprenant les étapes consistant à établir une batterie de filtres qui comprend plusieurs filtres passe-bande numériques et complexes ;
échantillonner la propriété du réseau électrique à déterminer afin d'obtenir des échantillons ;
fournir les échantillons à la batterie de filtres ;
estimer la fréquence fondamentale de la propriété à déterminer sur la base des échantillons ;
choisir, sur la base de l'estimation de fréquence, les filtres à partir des sorties desquels l'amplitude de chaque composant de fréquence peut être calculée ; et
calculer les amplitudes des composants fondamentaux et harmoniques de la propriété à déterminer à partir des sorties de la batterie de filtres, **caractérisé en ce que** la largeur combinée de la bande passante du filtre et d'une bande de transition est au moins égale à la valeur minimum de la fréquence fondamentale de la propriété à déterminer dans le réseau électrique, et les bandes passantes de deux filtres parallèles situés dans la batterie de filtres chevauchent N fois la fluctuation de la fréquence fondamentale qui est requise par l'ordre du filtre et qui se produit pendant la différence de temps entre le premier et le dernier échantillons d'un groupe d'échantillons, N étant l'ordinal de l'harmonique le plus élevé à mesurer.

2. Procédé selon la revendication 1, **caractérisé en ce que** la batterie de filtres utilisée est une batterie de filtres DFT équidistants, dont l'établissement comprend les étapes consistant à
établir un filtre basique ($H_0$), et
établir des filtres harmoniques ($H_n$) en dupliquant et en décalant le filtre basique de manière équidistante dans le domaine de fréquences.

3. Procédé selon la revendication 1 ou 2, **caractérisé en ce que** l'établissement de la batterie de filtres comprend l'étape d'établissement de la batterie de filtres en utilisant une partition polyphasée.

4. Procédé selon la revendication 3, **caractérisé en ce que** le calcul des amplitudes des composants fondamentaux et harmoniques comprend les étapes consistant à
sélectionner les filtres de la batterie de filtres dans la bande passante desquels un composant fondamental ou harmonique de la propriété à déterminer se produit,
calculer les résultats de la représentation polyphasée des sous-filtres dans la batterie de filtres DFT de bande M,
calculer la transformée inverse de Fourier du point M à partir des résultats obtenus pour la représentation polyphasée des sous-filtres par rapport aux filtres sélectionnés, afin d'obtenir la magnitude des parties réelles et imaginaires du signal fourni aux filtres sélectionnés lorsque M correspond au nombre total de filtres de la batterie de filtres, et calculer l'amplitude du composant harmonique à partir des parties réelles et imaginaires obtenues par rapport aux filtres sélectionnés de la batterie de filtres.

5. Procédé selon l'une quelconque des revendications 1 à 4, **caractérisé en ce que** la propriété à déterminer est la tension ou le courant dans le réseau électrique.

6. Appareil destiné à déterminer des harmoniques dans un réseau électrique, l'appareil comprenant un élément d'échantillonnage qui est agencé afin d'échantillonner la propriété du réseau électrique à déterminer, et comprenant également
une batterie de filtres qui comprend plusieurs filtres passe-bande numériques et complexes ;
un élément d'estimation de fréquence qui est agencé afin de sélectionner les filtres de la batterie de filtres dans la bande passante desquels les amplitudes harmoniques de la propriété à déterminer se produisent, et
un élément de traitement prévu pour la batterie de filtres afin de déterminer les amplitudes des composants fondamentaux et harmoniques de la propriété à déterminer, **caractérisé en ce que** la largeur combinée de la bande passante du filtre et d'une bande de transition est au moins égale à la valeur minimum de la fréquence fondamentale de la propriété à déterminer dans le réseau électrique, et les bandes passantes de deux filtres parallèles situés dans la batterie de filtres chevauchent N fois la fluctuation de la fréquence fondamentale qui est requise par l'ordre du filtre et qui se produit pendant la différence de temps entre le premier et le dernier échantillons d'un groupe d'échantillons, N étant l'ordinal de l'harmonique le plus élevé à mesurer.

7. Appareil selon la revendication 6, **caractérisé en ce que** la batterie de filtres est une batterie de filtres DFT équidistants qui comprend un filtre basique et des doubles du filtre basique décalés de manière équidistante dans le domaine de fréquences.

8. Appareil selon la revendication 6 ou 7, **caractérisé en ce que** la batterie de filtres est établie en utilisant une partition polyphasée.

9. Appareil selon l'une quelconque des revendications 6 à 8, **caractérisé en ce que** l'élément de traitement est agencé pour calculer les résultats des sous-filtres selon la partition polyphasée de la batterie de filtres DFT et l'amplitude de la propriété à déterminer à partir des résultats intermédiaires de la partition polyphasée, à l'aide du IDTF, par rapport aux filtres sélectionnés sur la base des signaux de sortie des filtres de la batterie de filtres.

10. Appareil selon l'une quelconque des revendications 6 à 9, **caractérisé en ce que** la propriété à déterminer est la tension ou le courant dans le réseau électrique.

FIG 1.

FIG 2.

FIG 3.

FIG 4.

Frequency-
reference
signal

Frequency
estimation
member
— 4

Filter
selection
— 5

Signal to be
analysed

Channel
selector
for
filters
6

H₀(z)
— 7

H₀(z)

H₀(z)

FIG 5.